# EUROPEAN PATENT APPLICATION

(11) **EP 2 278 344 A2**
(43) Date of publication of application: **26.01.2011**
(21) Application number: 10168103.9
(22) Date of filing: 01.07.2010
(51) Int. Cl.: G01R 15/20

(54) **Current sensing device**

(30) Priority: 10.07.2009 SE 0950549
(71) Applicant: Avalon Innovation AB, 374 35 Karlshamm (SE)
(72) Inventor: Stavervik, Mathias, 114 23 Stockholm (SE); Niva, Per, 120 55 Årsta (SE); Markström, Fredrik, 183 68 Täby (SE)
(74) Representative: Engdahl, Stefan

(57) **Abstract**

The invention provides contactless current sensing for a multi-wire electric cord based on measuring spatial variations in the magnetic field surrounding the cord. A current sensing device according to the invention includes a plurality of magnetometers, each adapted to measure the local magnetic flux density. Advantageously, such current sensing device is clamped around a portion of the electric cord. Embodiments suited for situations where there is a risk of inadvertent separation of the device from the cord include fastening means that cannot be disengaged by unarmed hands.

The device may operate independently or form part of a current sensing system, wherein one or more devices - each associated with a particular electric appliance - communicate wirelessly with a central unit. The central unit may emit an alert message when unintended use of an appliance is detected.

## Description

### Technical field

The invention disclosed herein generally relates to electric measurements and more particularly relates to a device for sensing current in local power distribution systems.

### Background of the invention

Safety systems with the general aim of preventing accidents caused by inadvertent operation of electric appliances are known in the art. A first group of such systems includes serially connected ammeters. Representative of this group, JP 2004/272771 discloses a system for sensing current which is simple to set up. An intermediary device in communication with a central device is connected between the electric plug and socket of each appliance to be monitored. The protective action of such a safety system could however be eliminated by mistake merely by disconnecting the intermediary device.

A second group of current sensing systems features contactless monitoring by sensing the electromagnetic field which accompanies every electric current. The measurement technique is similar to that of clamp-on ammeters, namely to determine the magnetic flux in a magnetically permeably measurement loop enclosing the electric conductor. Regrettably, such systems are only useful provided separate conduction wires are accessible and are possible to enclose by measurement loops. This in most practical situations requires assistance from a professional electrician. For instance, a conventional electric cord (cable) for direct current or one-phase alternating current is flowed by opposite currents of equal intensity at every instance, so that the net magnetic flux around the cord is zero. The same is true of three-phase cords.

Hence, it appears that the usefulness of available current sensing systems according to either of the principles outlined above is limited.

### Summary of the invention

In view of the above drawbacks, it is an object of the present invention to provide a reliable current sensing system which is easy to install. This is accomplished by a current sensing device, a central unit and a current sensing system in accordance with the independent claims appended hereto. The dependent claims disclose currently preferred embodiments.

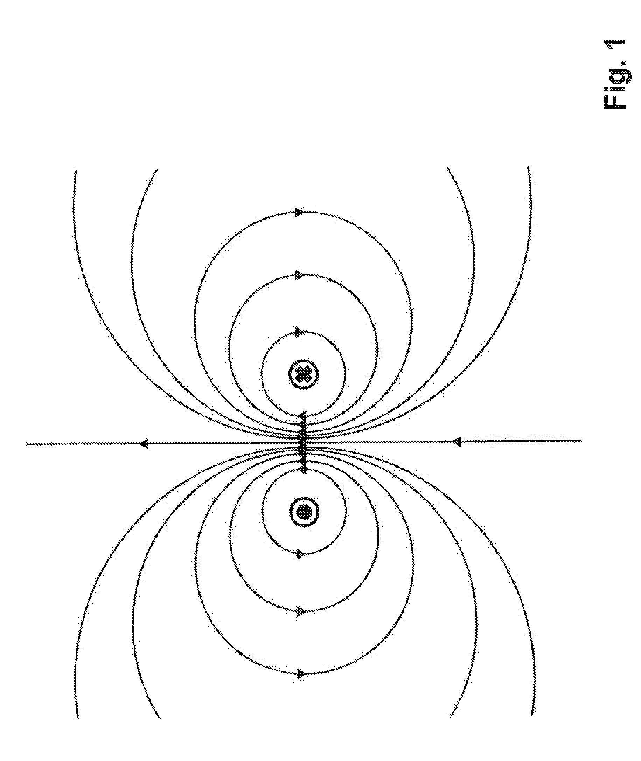

As one skilled in the art will realise when studying the claims, current sensing according to the invention is contactless and is based on detected spatial variations in the magnetic field around the electric cord in which current is to be sensed. To this end, a current sensing device according to the invention includes a plurality of magnetometers, each adapted to emit a signal indicative the local magnetic flux density. The signals from the magnetometers are processed by a current indicating means configured to detect such spatial flux variations that are characteristic of a magnetic field occurring in the vicinity of a multi-wire electric cord. Figure 1 shows field lines of a magnetic field generated by two parallel equal electric currents flowing in opposite directions perpendicularly to the plane of the drawing. The device is adapted to receive a portion of the electric cord in a passage and can be set in an open and a closed state. In the open state, an electric cord can be inserted into or removed from the passage, and in the closed state, it is not possible to separate the cord from the current sensing device.

The current sensing device has several advantages over related art, namely:
- Because the spatial variations of the magnetic flux is sensed, and not the total flux around the cord, the setup does not require dismantling the electric cord to access single wires.
- Because the device can be adjusted to an open state allowing the electric cord to be inserted into or removed from the passage, the setup does not involve disassembly of the electric appliance or other potentially dangerous equipment, such as the wall socket or the plug of the electric appliance.
- The device is adapted to be fixed to the electric cord of an appliance, unlike systems from related art having sensing devices that are associated with a wall socket, an electric wire powering a socket or the like. This ensures that the current sensing relates to one particular appliance.

In a preferred embodiment, the passage has such dimensions and mechanical properties (ridges and the like) that it retains the electric cord frictionally. For instance, the passage may be formed by two facing parts that are movable (e.g., hinged) relative to each other. The open state of the device then corresponds to the parts being separated.

Further, the passage may be maintained in its closed state by a fastening means. In embodiments for use in applications where there is a risk of undesired uncoupling of the current sensing device from the cord (e.g., by children or by memory-challenged adults), the fastening means is one that cannot be removed by unarmed hands, such as a screw, nut, bolt, (permanent) clip, rivet, tie wrap, magnetic lock, glued joint or the like. Preferably, the fastening means is operable only by means of an associated tool, at least for disengaging it. On the one hand, a screw requires a screwdriver both for being engaged and disengaged. On the other hand, there are known snap locks that engage just by bringing two parts together and which may be subsequently disengaged by depressing a small release actuator using a pointed tool, such as a nail, pin or pen.

Suitably, to achieve a gentle but reliable retention of the cord, the passage or a portion thereof is lined with a soft elastic material whose surface has a high frictional coefficient. Further preferably, the passage is undulated - it may for instance follow a soft S-like shape or be looped around a transversal pin - so that any tensile force applied to the cord increases the friction. An undulated passage may also exert a higher frictional force against a stiff electric cord than a straight passage would. To enhance the accuracy of the measurements, the passage should be such that the electric cord is maintained in a centred position. This can be achieved by means of a symmetric soft padding provided inside the passage.

As regards the measurement technique, advantageous embodiments of the invention include a band-pass filter centred around the frequency of the electric mains, to which the cord is connected. Indeed, any magnetic field generated by the cord by a current flowing therein will oscillate at this frequency. If the frequency filtering is narrow enough, shielding against external magnetic fields - notably the terrestrial magnetic field - is not imperative, at least not in alternating current systems.

Suitable spatial placements of the magnetometers can be determined based on the nature of the magnetic field which is expected to occur around the electric cord, as will be detailed below. As a guiding principle for the placement, the magnetometers should be disposed in a such manner that current sensing can be performed irrespective of the orientation of the electric cord.

The current sensing device may be part of a current sensing system, notably a home safety system, or be used alone. In the latter case, the device includes some signalling means for providing an audible, visible or vibratory signal to notify a user of the momentary (or lasting) presence of electric current. The notification may be indirect, notably via an ultrasonic signal audible to a guide dog, which notifies the user. If the current sensing device is instead used as part of a current sensing system, it includes a wireless transmitter for transmitting data indicating the presence or absence of electric current. When the data are transmitted in a wireless fashion, the nature of the fastening means referred to above becomes particularly important. Indeed, because the current sensing device is then easily movable, it should not be easily separated from the appliance it is intended to monitor. Preferably, the fastening means of the wireless sensing device, which ensures its association with the appliance, e.g., by holding the electric cord of the appliance, cannot be removed by unarmed hands.

In one embodiment, a current sensing device is adapted to alert a human being (user) in response to a positive current indication throughout a predetermined time period. Thus, on the one hand, the device may alert the user if there has been any positive current indication in a preceding time period. This avoids false negative indications for certain appliances, which in their connected/active mode alternate between a relatively high current and a near-zero current. This is in particular true of thermostat-controlled devices, such as electric flat irons. If the current sensing device is consulted at isolated points in time, such as upon the user's leaving his or her dwelling, connected appliances of this kind may be connected unnoticed. On the other hand, detection over a predetermined time period may be used to avoid false positive current indications, especially if the current sensing device is consulted on a continuous basis, e.g., when the user is in his or her dwelling. In these circumstances, one may expect that appliances are used during time periods that are normal with regard to the type of appliance, such as the use of a kitchen range for the time it usually takes to cook a meal, while use during longer periods can be expected to be unintentional. Therefore, a continuous current sensing for the whole duration of a predetermined time period may help discern normal use of an appliance from a potentially dangerous situation.

A current sensing system in accordance with the invention generally comprises at least one current sensing device having the above characteristics and adapted to communicate wirelessly with a central unit. In addition to the wireless receiver, the central unit has a processing means for processing current indications from the current sensing devices and a user interface for indicating a current sensing status to a user. The user interface preferably includes a visual display capable of displaying graphic information. It may further include means for generating an acoustic or tactile alert signal.

In an advantageous embodiment, the central unit is adapted to poll each current sensing device. If polling is performed periodically, it decreases the sensitivity of the system to a malfunction, such as a battery failure or a radio transmission error. The polling itself may be triggered by a movement detector indicating whether anyone is within hearing or sight of the central unit.

### Brief description of the drawings

Embodiments of the present invention will now be described with reference to the accompanying drawings, on which:
figure 1 shows a magnetic field in the vicinity of two opposite electric currents in a plane perpendicular to the currents;
figure 2 includes several external views of current sensing devices according to two embodiments of the invention;
figure 3 is a cut-away side view of the current sensing device shown in figure 2;
figure 4 shows a placement, in relation to the magnetic field of figure 1, of magnetometers in a current sensor according to an embodiment of the invention;
figure 5 is a circuit diagram of a current sensor according to an embodiment of the invention;
figure 6 is a perspective view of a central unit in a current sensing system according to an embodiment of the invention;
figure 7 is a schematic drawing of a current sensing system in accordance with an embodiment of the invention;
figure 8 shows magnetic fields in the vicinity of a set of current-flowed three-phase conductors in a plane perpendicular to the currents, at three time instants; and

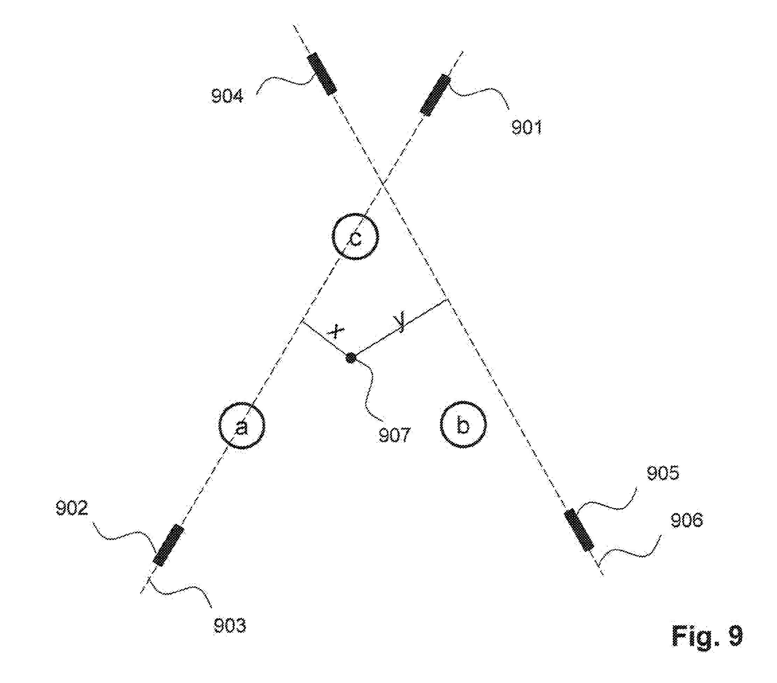

figure 9 shows a placement, in relation to the conductors shown in figure 8, of magnetometers in a current sensor according to an embodiment of the invention.

Like numerals refer to like parts on the drawings unless otherwise indicated.

### Detailed description of embodiments

In addition to the embodiments which will be described in what follows, the invention may be embodied in many different forms and should not be construed as being limited to the embodiments set forth herein; rather, these embodiments are provided by way of example so that this disclosure will be thorough and complete, and will fully convey the scope of the invention to those skilled in the art.

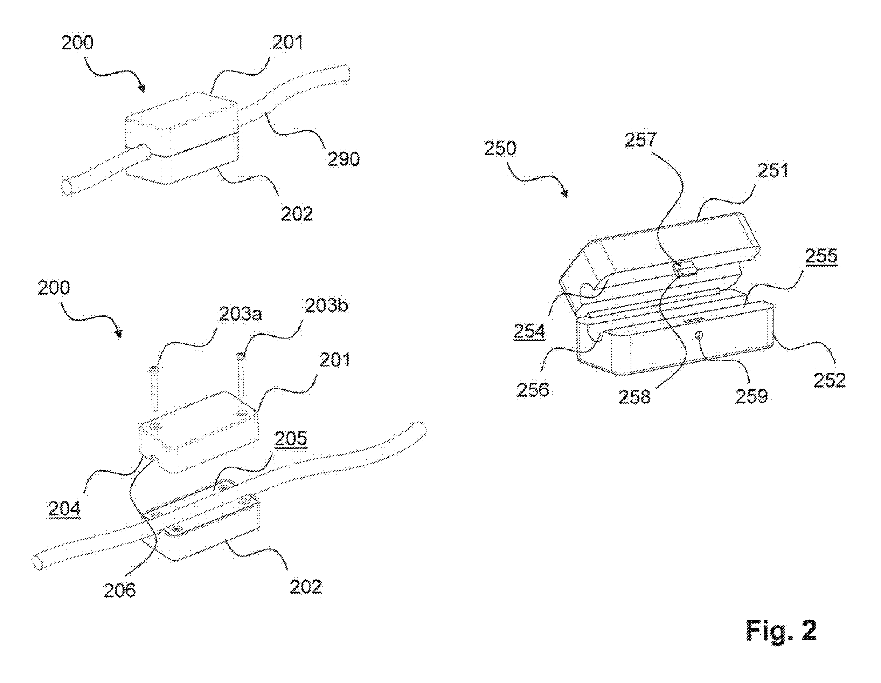

Figure 2 shows the external appearance of current sensing devices 200, 250 according to two embodiments of the invention. A first device 200, which is shown both in an open and a closed state on the drawing, is divided into two parts 201, 202. In the closed state, the parts 201, 202 are kept together by means of a plurality of screws 203. With all screws disengaged, the parts 201, 202 are independently movable relative to one another. The mating surfaces 204, 205 of the respective parts 201, 202 together form a passage 206 for receiving a portion of an electric cord 290 for supplying an applicance with electric power. The device 200 is adapted to sense current in the electric cord 290. The passage 206 fits rather tightly to the cord 290, which causes frictional retention; besides, the electric plug and the body of the electric appliance ensure, having a much larger diameter than the cord, ensure that the current sensing device 200 cannot be removed from either end of the cord 290 unless the screws 203 are disengaged.

A second current sensing device 250 consists of two parts 251, 252 of a similar constitution as those of the first device 200. However, the parts 251, 252 are here hinged together and thus only rotatably movable relative to one another. The parts 251, 252 are kept together in a closed position by means of a snap lock 257 which engages by folding the parts 251, 252 together. Because this embodiment is chiefly aimed at memory-challenged users, who may inadvertently uncouple the device 250 from an electric cord (not shown), the snap lock 257 can only be released by depressing a locking hook 258 by introducing a pointed tool (not shown) through a hole 259. Upon closure of the snap lock 257, mating surfaces 254, 255 form a passage 256 for receiving the cord. To ensure a reliable though gentle frictional retention of the cord, the passage 256 is padded with a softer material that helps distribute the retaining force over the surface of the cord by yielding elastically at points of high mechanical pressure. This means the exact diameter of the cord is not crucial for ensuring a reliable mechanical functioning of the device 250. Moreover, the padding contributes to maintain the cord in a central position with respect to the passage.

In an alternative embodiment, the current sensing device consists of a single body of an elastically deformable material, such as rubber or moulded plastic. When mechanically relaxed, the device is in its closed state and does not let an electric cord pass. When parting forces are applied to the device, the device is in its open state, permitting an electric cord to be inserted or removed. As an example, the device may be shaped as an open annulus having a gap smaller than the diameter of an electric cord.

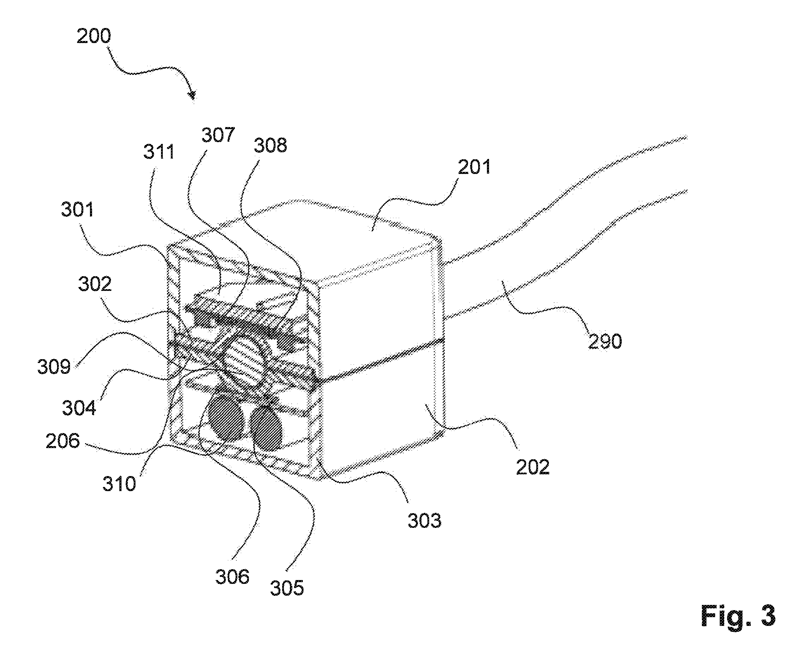

Figure 3 is a cut-away side view of the first current sensing device 200 with an electric cord 290 present in the passage 206. The first part 201 is physically bounded by an outer housing 301 and an inner housing 302 facing the cord 290. Likewise, the second part 202 comprises outer and an inner housings 303, 304. Four magnetometers 305, 306, 307, 308 are arranged around the cord 290 in a plane proximal to the cut of the drawing; details concerning the placement will be discussed below. The magnetometers 305, 306, 307, 308 are preferably of a type capable of sensing the strength of a local magnetic field. More precisely, the magnetometers may be adapted to measure the magnitude of the magnetic field component in a predetermined measurement direction. Advantageously, Hall-effect sensors are used. It is emphasised that inductive means for measuring magnetic fields - notably cores of highly permeable material (e.g., iron) with windings - are not well suited for embodying the present invention, primarily because of their poor localisation and/or directivity.

The device 200 further includes a current indicating means 309, which is connected to the magnetometers 305, 306, 307, 308 and adapted to process output data from these. Based on the output data, the current indicating means 309 determines whether electric current flows in the cord 290. Batteries 310 supply the components of the device 200 with electric power. In this embodiment, the device 200 is adapted to form part of a current sensing system, and therefore comprises a wireless transmitter 311. The wireless transmitter 311 may be a radio-frequency transmitter or transceiver, such as a Bluetooth®, VHF or WLAN transmitter or a transmitter in accordance with the IEEE 802.4.15 standard. The latter is well suited in view of typical transmission distances in a building, of the relatively low bit rates and of the relatively high requirements on communication reliability and energy economy. More preferably still, the transmitter 311 uses a ZigBee® protocol.

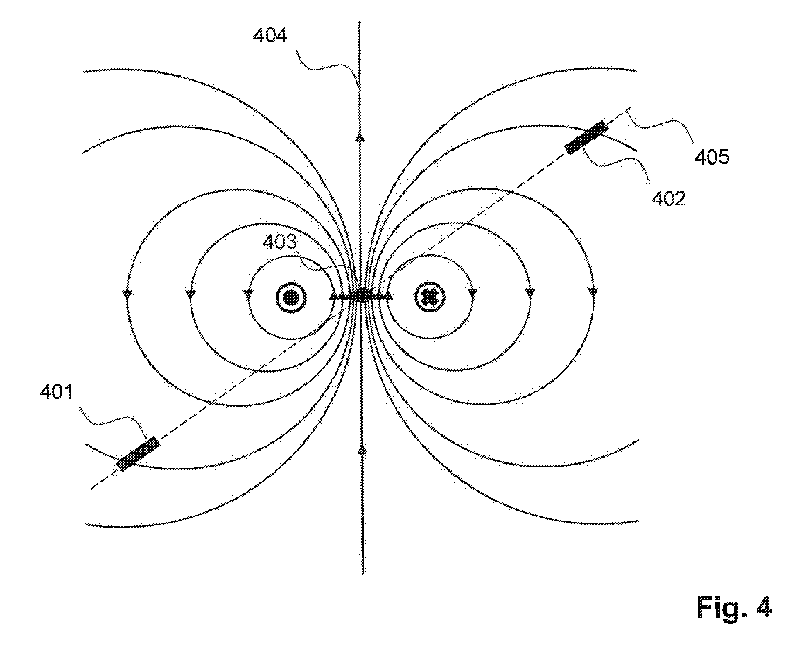

Figure 4 reproduces the magnetic field shown in figure 1, and shows a placement of two magnetometers 401, 402. The placement is advantageous for sensing a magnetic field of the type occurring around two opposite electric currents. The magnetometers 401, 402 are located at equal distances from the geometric centre 403 of the field and are collinear with the centre 403. Preferably, the sensing directions of the magnetometers 401, 402 is the azimuth, that is, the direction perpendicular to both the electric currents to be sensed and to the symmetry line 405 through the magnetometers 401, 402 and the centre 403 of the field. This implies that the magnetometers 401, 402 will record values of the local magnetic field component that are essentially equal at every instant.

The described placement of the magnetometers may be adopted in a variety of electric current sensing devices, not only those disclosed in the present application. A common property of such devices is their ability of sensing electric current in multi-wire conductors, in which single wires cannot be accessed individually.

It is noted that two magnetometers which were identically arranged in relation to a cord with just one electric wire would record opposite values, since the magnetic field lines then would be concentric circles.

In practice, the proper alignment of the currents and the magnetometers 401, 402 is achieved by ensuring that the electric cord 290 is in a centred position in the passage 206. Indeed, the centre of the cord 290 approximately coincides with the centre 403 of the magnetic field, and the magnetometers 401, 402 are arranged symmetrically around the passage 206. However, unless the electric cord 290 has a flat or oval outer cross section, there is no easy way of knowing its orientation, as determined by the two wires. The magnetic measurement is most efficient when the straight magnetic field line 404 is normal to the symmetry line 405. At small angles between the straight line 404 and the symmetry line 405, relatively faint measurement signals will be recorded. Therefore, to provide reliable current sensing irrespective of the orientation of the cord 290, it is advantageous to arrange a second pair of magnetometers (not shown) on a second symmetry line (not shown) perpendicular to that of the existing magnetometers 401, 402. Thus, for sensing current in two-wire electric cords, the preferable number of magnetometers is four.

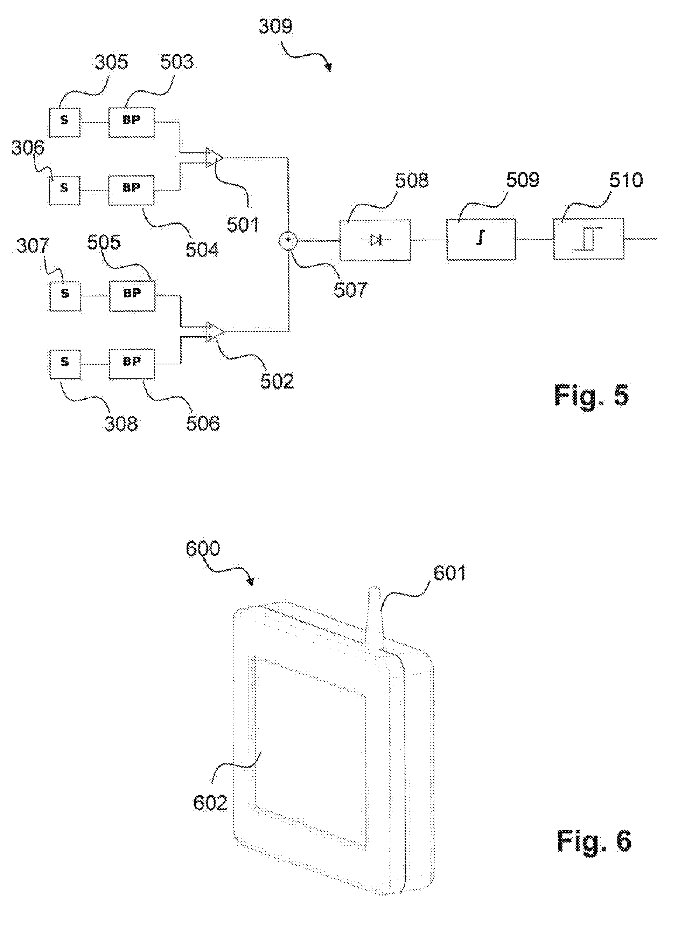

Figure 5 is a circuit diagram showing the principal components of the current indicating means 309 in the current sensing device 200. It is recalled that the device 200 comprises four magnetometers 305, 306, 307, 308. Pairs of measurement signals from opposite magnetometers are fed to respective differential amplifiers 501, 502. In this embodiment, which is adapted to sense alternating current, the current indicating means 309 further includes band-pass filters 503, 504, 505, 506 connected between each magnetometer 305, 306, 307, 308 and its associated differential amplifier 501, 502. The band-pass filters 503, 504, 505, 506 are adapted to provide selective filtering (their Q values are large) centred at the nominal frequency of the alternating current. The signals from the differential amplifiers 501, 502, which are indicative of the contributions from the magnetometer pairs, are fed to a summing means 507. By an appropriate selection of the orientations of the magnetometers 305, 306, 307, 308 and the polarities of the differential amplifiers 501, 502, contributions are added with like signs by the summing means 507. An integrator 509 computes a sliding time average of the signal from the summing means 507 after this has been processed by a rectifier 508. Finally, a threshold circuit 510 provides a binary output signal indicative of the presence of current exceeding a predetermined threshold. The threshold may be chosen in accordance with the intended use of the current sensing device 200: a relatively small threshold can be chosen if the intention is to detect operation of an electric appliance, whereas a larger threshold - ignoring, e.g., a standby mode of the appliance - is appropriate if the primary goal of the device 200 is to prevent fires caused by heat-producing equipment.

Figure 6 is an external view of a central unit 600, which is adapted to form a current sensing system when combined with one or more current sensing devices, such as the devices 200, 250 discussed above. The central unit 600 comprises a wireless receiver 601 for receiving a current indication from a current sensing device (not shown), a processing means (not shown) for processing the received current indication and a user interface 602 for displaying graphical information and, optionally, an acoustic or tactile signal for alerting a human user indirectly (such as via a guide dog) or directly. In particular the user interface 602 may display an image of an electric appliance for which a positive current indication exists; the association of current sensing devices and images may take place as part of a setup procedure of the central unit 600. Furthermore, the central unit 600 may include a movement detector (not shown) for activating the user interface, which may be in an energy-saving mode until a nearby user is detected. Possibly, and especially if the central unit 600 is not capable of emitting far-reaching alert signal, such as an acoustic signal, the measurements necessary for current sensing may be entirely suspended until a person is near enough to see the user interface 601.

To achieve a reliable operation of the system, the communication protocol used by the central unit 600 may be adapted to poll the local current sensing devices regularly. If a local device fails to respond, then a malfunction is likely to have occurred and the user should be notified. Malfunction may be caused by low battery voltage, a removal of the current sensing device into an area where the radio coverage is insufficient, or by a hardware failure. Communication protocols according to which the local units transmit only when current is sensed may be unreliable, since both absence of current and fault conditions will yield identical results from the point of view of the central unit 600.

In the same vein, a local current sensing device may be adapted to notify the central unit 600 when actuated into its open state, in which the electric cord can be removed. This advantageously prevents inadvertent disconnection of the current sensing device. Similarly but simpler, the wireless transmitter may be rendered inoperable when the current sensing device is in its open state, so that no positive polling response is given until the device has been properly fitted.

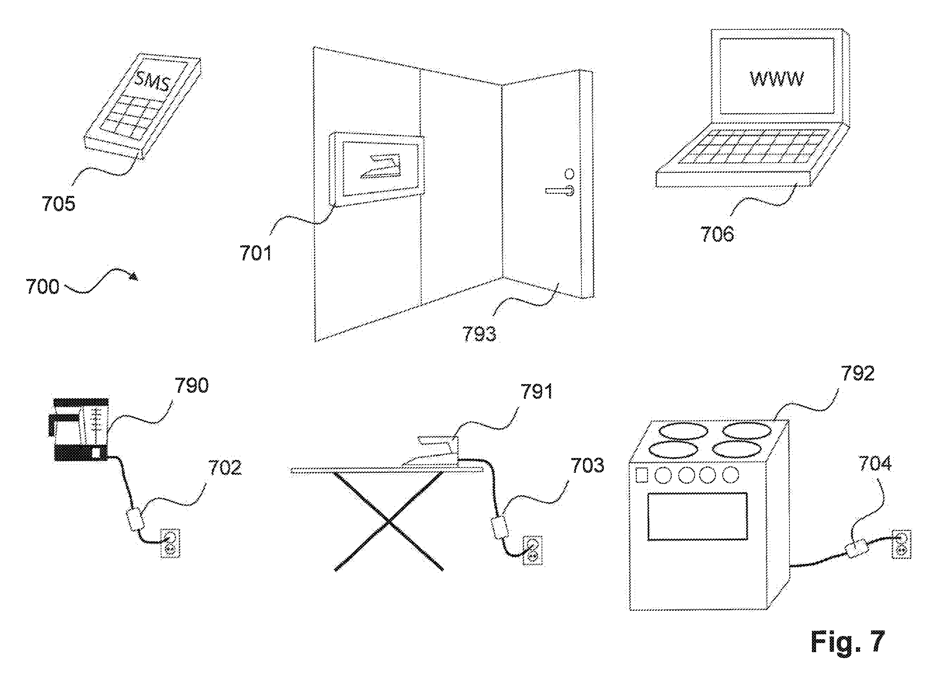

Figure 7 is a schematic drawing of a current sensing system 700 according to an embodiment intended for use in a dwelling. The system 700 comprises a central unit 701, similar to the central unit 600 shown in figure 6, and a plurality of local current sensing units 702, 703, 704 similar to the devices 200, 250 of figure 2 and adapted to communicate wirelessly with the central unit 701. The current sensing units 702, 703, 704 are fitted around electric cords which respectively supply a coffee machine 790, a flat iron 791 and a kitchen range 792 with electric power. As shown on the drawing, each current sensing unit 702, 703, 704 is provided on the electric cord segment extending between the electric plug and the respective appliance 790, 791, 792. Thus, without tools or without destroying the equipment it is not possible to dissemble the current sensing unit from its associated appliance, which ensures that a current indication obtained from the unit really relates to the desired appliance. As another consequence of the sensing unit being associated with the appliance's own cord (rather than, e.g., to an electric wall socket), a negative current indication can be interpreted to imply, with reasonable certainty, that the appliance is inactive or disconnected. The central unit 701 is wall-mounted to increase visibility and is preferably located near an entrance door 793 of the dwelling. The signal power used for the wireless communication between the nodes of the system 700 is chosen in accordance with the dimensions of the dwelling. If the communication protocol provides for communication via intermediary nodes (forwarding of messages), then some signal power may be economised by deploying a further local sensing device, whose primary function is to bridge communications between distant nodes, not to act as a current sensor.

Also shown in figure 7 are a mobile telephone 705 and a portable personal computer 706. The central unit 701 may be connected to each of these - respectively via communication means such as a mobile telephone network or the Internet - for enabling remote current sensing. For instance, the central unit 701 may sand an alert message to the user's mobile telephone 705 via the Short Message Service if the system 700 detects current although the dwelling is empty.

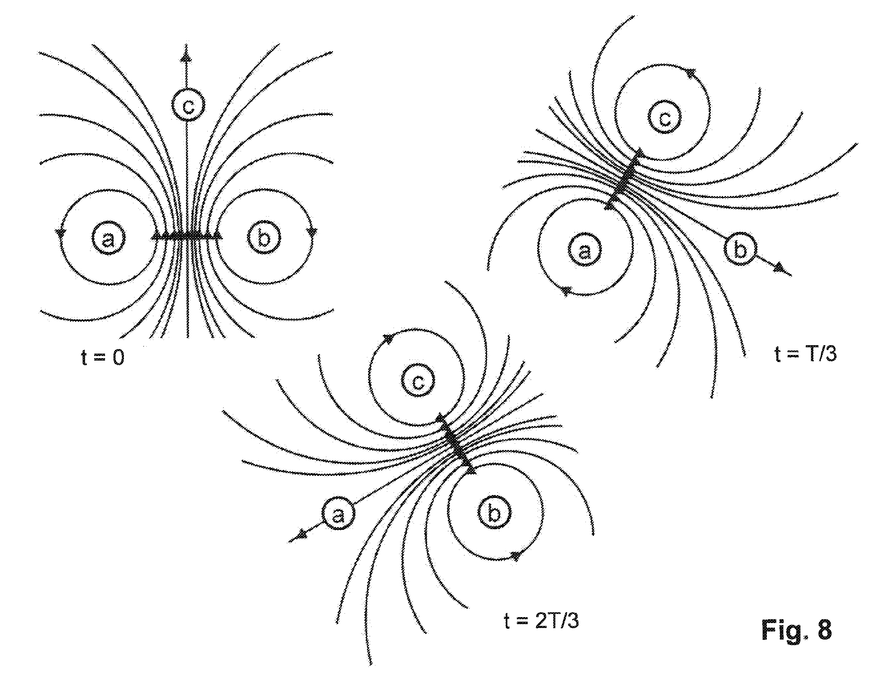

Figure 8 shows magnetic field lines around three electric conductors a, b, c which are perpendicular to the plane of the drawing and carry three-phase alternating current. As those skilled in the art know, large household appliances, notably kitchen ranges, are usually supplied by three-phase alternating power. Because the total net current in the three wires is zero at every instant, a conventional clamp-on ammeter is not capable of sensing current in the cord. The magnetic field lines are shown at three instants, t = 0, t = T/3 and t = 2T/3, where T is the period of the alternating current, e.g., 20 ms in a 50-Hz system. Thus, the three images are separated by a phase difference of 120 degrees. At t = 0, the momentary current in the upper conductor c is zero, and the momentary currents through the two lower conductors a, b are opposite and equal. Thus, at this instant, the lower conductors a, b produce a magnetic field similar to that of the currents shown in figure 1. At t = T/3, it is the right conductor b that is flowed by zero current, so that the left and upper conductors a, c carry opposite and equal momentary currents. This means the magnetic field has rotated by 120 degrees clockwise in comparison with the situation at t = 0. Similarly, the field will appear to have rotated by another 120 degrees clockwise at t = 2T/3.

The placement of magnetometers for sensing current in a three-phase cord is similar to the case of a two-phase cord. The placement is easier in so far as the rotating magnetic field does not have a fixed orientation and therefore is independent of the azimuthal orientation of the electric cord. On the other hand, the placement is rendered more complicated by the absence of geometric symmetry of the field with respect to the centre of the electric cord. Thus, if a pair of magnetometers 901, 902 are provided in a similar fashion as shown in figure 4, namely, at equal distances from the centre of the cord, then the symmetry line 903 of the magnetometers should not intersect the centre 907 of the passage (and thus, the intended centre of the cord). Rather, the symmetry line 903 should intersect two of the electric conductors and be centred with respect to their midpoint. The distance between the line 903 and the centre 907 of the passage is denoted by x. By virtue of the periodic rotation of the magnetic field, it is immaterial which two electric conductors are used as a reference for placing the magnetometers 901, 902. A difficulty that arises in this connection, however, is the uncertainty relating to the actual separation of the electric conductors, which varies between different electric cords as a function of the cross-section area of the wires, the amount of insulation etc. To make the current sensing device more versatile to different cord types, the disclosed embodiment includes further magnetometers 904, 905 arranged on a line 906 that is separated from the centre 907 of the passage by a distance y distinct from x.

While the invention has been illustrated and described in detail in the drawings and foregoing description, such illustration and description are to be considered illustrative or exemplary and not restrictive; the invention is not limited to the disclosed embodiment. It is understood that some components that are included in the disclosed embodiments are optional. Notably, regarding two-phase current sensing, it may prove sufficient in many domestic applications to use only two magnetometers.

Other variations to the disclosed embodiments can be understood and effected by those skilled in the art in practicing the claimed invention, from a study of the drawings, the disclosure, and the appended claims. The mere fact that certain measures are recited in mutually different dependent claims does not indicate that a combination of these measures cannot be used to advantage. Any reference signs in the claims should not be construed as limiting the scope.

## Claims

1. A current sensing device comprising:
a plurality of magnetometers;
a current indicating means coupled to said magnetometers;
a passage; and
a wireless transmitter for transmitting a current indication,
wherein the current sensing device is adjustable to a closed state, in which the passage is adapted to enclose a portion of an electric cord in which current is to be sensed, and an open state, in which a portion of an electric cord can be inserted into or removed from the passage.

2. A current sensing device according to claim 1, further comprising a fastening means adapted to maintain the passage in its closed state, the fastening means being releasable only by means of an associated tool.

3. A current sensing device according to claim 2, wherein adjusting the passage to its closed state causes the fastening means to engage.

4. A current sensing device according to claim 1, wherein the passage, in its closed state, is adapted to frictionally retain the electric cord.

5. A current sensing device according to claim 2, wherein the fastening means is at least one of the following:
a screw joint,
a clip,
a rivet,
a tie wrap,
a magnetic lock, and
a glued joint.

6. A current sensing device according to any one of the preceding claims, wherein at least a portion of said passage is undulated.

7. A current sensing device according to any one of the preceding claims, wherein the passage is adapted to maintain, in its closed state, the electric cord essentially centred with respect to the passage.

8. A current sensing device according to any one of the preceding claims, wherein the current indicating means comprises a band-pass filter adapted to transmit an electric mains frequency.

9. A current sensing device according to any one of the preceding claims, wherein a first and a second magnetometer are arranged symmetrically with respect to the centre of the passage in a plane normal to the passage; and the current indicating means is adapted to process outputs of the first and the second magnetometer.

10. A current sensing device according to any one of the preceding claims, further comprising a signalling means for alerting a human being.

11. A current sensing device according to claim 10, wherein the signalling means is adapted to emit an acoustic signal.

12. A current sensing device according to claim 10 or 11, wherein the signalling means is adapted to alert a human being in response to a positive current indication throughout a predetermined time period.

13. A current sensing system comprising:
at least one current sensing unit according to claim 1;
a central unit comprising:
a wireless receiver adapted to receive a current indication from said at least one current sensing unit;
a processing means; and
a user interface.

14. A current sensing system according to claim 13, wherein:
the central unit is adapted to periodically poll said at least one current sensing unit; and
the central unit comprises a movement detector adapted to trigger said polling.

15. A method of sensing current in a multi-wire electric cord, the method comprising:
measuring an electric-mains frequency component of a local magnetic flux density at a plurality of points around the cord;
determining, based on the spatial variation of the measured flux density, whether current flows in the cord; and
wirelessly transmitting a current indication.
